(19) Europäisches Patentamt
European Patent Office
Office européen des brevets

(11) **EP 4 749 299 A1**

(12) **EUROPEAN PATENT APPLICATION**

(43) Date of publication:
27.05.2026 Bulletin 2026/22

(21) Application number: 24214683.5

(22) Date of filing: 22.11.2024

(51) International Patent Classification (IPC):
*G01R 31/08* (2020.01)     *H02H 9/08* (2006.01)

(52) Cooperative Patent Classification (CPC):
**H02H 9/08**; G01R 31/086

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
• **Siermala, Saku**
**65320 Vaasa (FI)**
• **Leminen, Janne**
**33720 Tampere (FI)**
• **Altonen, Janne**
**33720 Tampere (FI)**

(74) Representative: **Kolster Oy Ab**
**Salmisaarenaukio 1**
**P.O. Box 204**
**00181 Helsinki (FI)**

(54) **METHOD AND APPARATUS FOR CONTROLLING ARC SUPPRESSION DEVICE**

(57)     A method and apparatus for controlling an arc suppression device of a three-phase electric network, the arc suppression device having an adjustable admittance connected between a neutral point of the three-phase electric network and earth, the apparatus being configured to perform (110) a current injection into the neutral point of the three-phase electric network by using a frequency different from a frequency of the three-phase electric network, obtain (120) a value of a zero-sequence impedance of the three-phase electric network and/or obtain (120) a value of a zero-sequence admittance of the three-phase electric network, and determine (130), based on the obtained value of the zero-sequence impedance and/or based on the obtained value of the zero-sequence admittance, whether to initiate a tuning of the arc suppression device of the three-phase electric network.

Fig. 3

EP 4 749 299 A1

**Description**

TECHNICAL FIELD

The present invention relates to a method and an apparatus for controlling an arc suppression device.

BACKGROUND

An arc suppression device can be used for compensating a fault current caused by a single-phase-to-earth fault. An example of the arc suppression device is an Arc Suppression Coil, ASC, which is a passive inductive device that is connected between a neutral point of an electric system (e.g. network) and earth to limit the capacitive earth-fault current flowing, when a single-phase-to-earth fault occurs in the system. The ASC was originally developed by Waldemar Petersen and is therefore sometimes referred to as the Petersen Coil. This kind of system earthing method may be called as the resonant earthing. The resonant earthing is a commonly used earthing practice in medium voltage networks, for example, and it has been used in several countries for many decades with good operational experiences. An example of the ASC is disclosed in US 1537371. An electric network provided with one or more such arc suppression devices may be referred to as a compensated network.

The idea of the resonant earthing may be generally to match, either essentially completely or at least partially, an admittance of the arc suppression device(s) to the total phase-to-earth capacitance formed by the network conductors. In this case the magnitude of the earth-fault current at the fault location can be limited below the level of self-extinguishment, which can suppress transient earth faults without a feeder tripping, for example. Also, the touch and hazard voltages can be limited with the decreased fault current value, which also can limit the danger to public and property, and improve safety to personnel, for instance.

In order to set the admittance value of the arc suppression device(s) to match the total phase-to-earth capacitance of the network conductors, at least an inductance, provided by e.g. one or more adjustable coils, of the arc suppression device may be variable and a controller device (e.g. a coil controller) can be used. The purpose of such a controller device is to adjust, i.e. tune, the arc suppression device admittance to match, either essentially completely or at least partially, the total phase-to-earth capacitance value of the network. And if the phase-to-earth capacitance value of the network changes, the controller device may again adjust (tune) the admittance of the arc suppression device(s) to match the changed phase-to-earth capacitance value of the network.

When changes in the compensated network occur, the size of the galvanically connected network may change. As the lines of the network have a specific line-to-earth capacitance per kilometer, the total line-to-earth capacitance of the network may vary depending on the network topology, for example. Therefore, the tuning of the arc suppression device(s) should preferably correspond to the prevailing network topology, which means that e.g. after a change in the network topology, the arc suppression device(s) may have to be tuned (or retuned). It is therefore preferable to automatically and reliably detect changes in the network configuration or generally changes in the tuning of the arc suppression device(s) so that it can be determined if the (re)tuning of the arc suppression device of the electric network should be initiated (triggered) in order to determine a new tuning point for the arc suppression device(s).

One way to determine whether to initiate the tuning of the arc suppression device of the three-phase electric network may be based on monitoring changes in the (absolute or phasor) value of the zero-sequence voltage of the network which indicate changes in the network. However, to reliably detect changes in the zero-sequence voltage, a sufficient level of natural zero-sequence voltage should be present in the network. This may set a limit for allowed symmetry of the network, for instance. For example, when a symmetrical line section is switched on in the network, there may be essentially no sufficient change in the zero-sequence voltage of the network and such a change in the switching state or the network configuration may not be detected by such monitoring of the zero-sequence voltage of the network, for example. Moreover, rapid changes in the zero-sequence voltage of the network can also occur without changes in the network configuration due to strong load current fluctuations, capacitively coupled signals and/or due to short-term fluctuations in the network frequency, for example, which may lead to unreliable detection of changes in the network configuration.

BRIEF DESCRIPTION

An object of the present invention is thus to provide a method and an apparatus for implementing the method so as to overcome the above problem or at least to alleviate the above problem. The object of the invention is achieved by a method and an apparatus which are characterized by what is stated in the independent claims. The preferred embodiments of the invention are disclosed in the dependent claims.

The invention is based on the idea of performing a current injection into the neutral point of the three-phase electric network by using a frequency different from a frequency of the three-phase electric network, obtaining a value of a zero-sequence impedance of the three-phase electric network, or of a quantity representative of the zero-sequence impedance of the three-phase electric network, during the current injection, and/or obtaining a value of a zero-sequence admittance of the three-phase electric network, or of a quantity representative of the zero-sequence admittance of the three-phase electric network, during the current injection, and determining, based on the obtained value of the zero-sequence impedance, or of the quantity representative thereof, and/or based on the obtained value of the zero-sequence admittance, or of the quantity representative thereof, whether to initiate a tuning of the arc suppression device of the three-phase electric network.

An advantage of the solution of the invention is that it is robust and applicable also in connection with symmetrical networks or portions thereof for determining whether to initiate the tuning of the arc suppression device of the three-phase electric network. Moreover, the solution of the invention enables a fast determination of whether the tuning of the arc suppression device of the three-phase electric network should be initiated.

BRIEF DESCRIPTION OF THE DRAWINGS

In the following the invention will be described in greater detail by means of preferred embodiments with reference to the accompanying drawings, in which

Figure 1 is an example of a three-phase electric network illustrating an embodiment;
Figure 2 is an example of a three-phase electric network illustrating an embodiment;
Figure 3 illustrates a flow diagram according to an embodiment;
Figure 4 illustrates a diagram according to an embodiment; and
Figure 5 illustrates a block diagram according to an embodiment.

DETAILED DESCRIPTION

The following embodiments are exemplary. Although the description may refer to "an", "one", or "some" embodiment(s) in several locations, this does not necessarily mean that each such reference is to the same embodiment(s), or that the feature only applies to a single embodiment, for example. Single features of different embodiments may also be combined to provide other embodiments. Generally, all terms and expressions used should be interpreted broadly and they are intended to illustrate, not to restrict, the embodiments. The figures only show components necessary for understanding the various embodiments. The number and/or configuration of the various elements, and generally their implementation, could vary from the examples shown in the figures.

Different embodiments and examples may be described below using single units, models, equipment and memory, for example, without restricting the embodiments/examples to such a solution. Concepts called cloud computing and/or virtualization may be used. The virtualization may allow a single physical computing device to host one or more instances of virtual machines that appear and operate as independent computing devices, so that a single physical computing device can create, maintain, delete, or otherwise manage virtual machines in a dynamic manner. It is also possible that device operations will be distributed among a plurality of servers, nodes, devices or hosts. In possible cloud computing network devices, computing devices and/or storage devices may provide shared resources. Some other technology advancements, such as Software-Defined Networking (SDN), may cause one or more of the functionalities described below to be migrated to any corresponding abstraction or apparatus or device. Therefore, all words and expressions should be interpreted broadly, and they are intended to illustrate, not to restrict, the embodiment in question.

The application of the various embodiments described herein is not limited to any specific system, but it can be used in connection with various three-phase electric networks with a compensated neutral, also known as resonant-earthed networks, where compensation of fault current is achieved by installing one or more arc suppression devices, such as Arc Suppression Coils (ASC), also known as Petersen coils or compensation coils, into neutral point(s) (star point, zero point) of the system. The electric network, in which the various embodiments may be implemented, can be an electric power transmission and/or distribution network or a portion or a component of a larger network, for example, and may comprise several electric lines and/or sections. The electric network may have a radial configuration supplied from one point thereof or a loop configuration comprising one or more loops and supplied from two or more points, or a combination of such configurations, for instance. Moreover, the use of the various embodiments is not limited to systems employing 50 Hz or 60 Hz fundamental frequencies or to any specific voltage level. Also a phase rotation order, such as L1-L2-L3 or L1-L3-L2, of the system does not limit the use of the various embodiments.

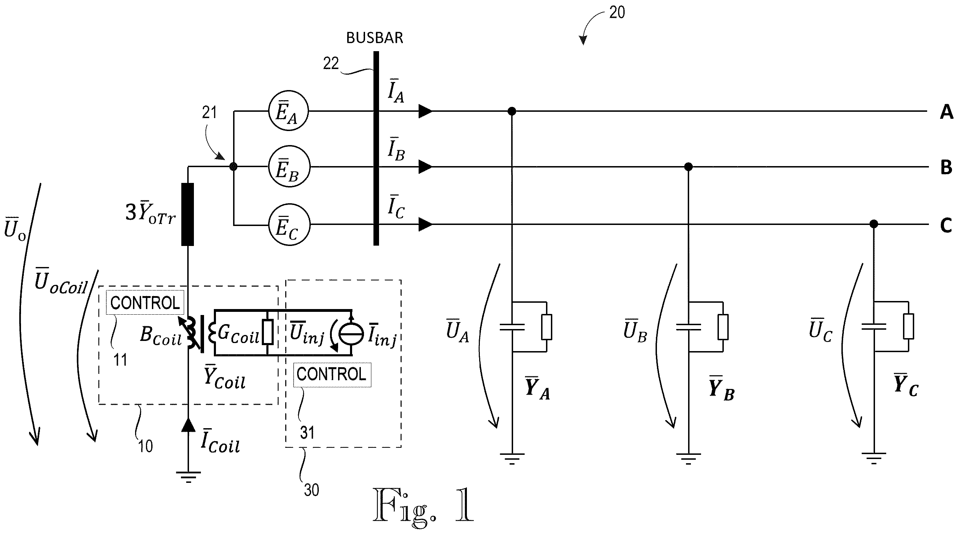

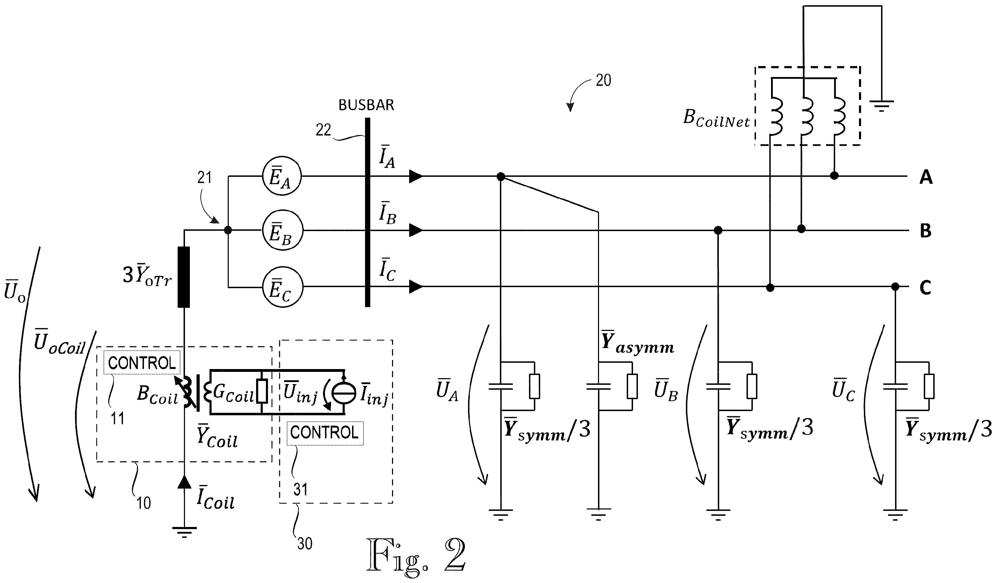

Figures 1 and 2 are simplified diagrams of an exemplary electric system (network) showing some equipment (e.g. apparatuses, devices, nodes) and functional entities, whose implementation and/or number and/or configuration may differ from what is shown in the examples of Figures 1 and 2. Such a system may also comprise other equipment, functional entities and/or structures, some of which used in or for big data, data management, and communication in the system or in any part of the system, for example. Also e.g. any communications protocols used may vary and may depend on the system characteristics, for instance. Figures 1 and 2 are diagrams illustrating simplified equivalent circuits of a three-phase electric network in which the various embodiments can be applied. The exemplary three-phase network with phases A, B and C may be a medium voltage (e.g. 20 kV) distribution network fed through a substation comprising a source $\overline{E}_A, \overline{E}_B, \overline{E}_C$, such as a transformer or generally a feeding point of the electric network, and a feeding busbar 22 connected to one or more electric line outlets (feeders) 20, for example. Respective phase currents of phases A, B and C are $\bar{I}_A, \bar{I}_B$, and $\bar{I}_C$, with a positive current direction from the feeding point towards line as indicated by the arrows in the figure, and respective phase voltages are $\overline{U}_A, \overline{U}_B$, and $\overline{U}_C$. Figures 1 and 2 further illustrate an arc suppression device (apparatus, equipment) 10, which is connected between a neutral point (star point, zero point) 21 of the three-phase electric network and earth. The arc suppression device 10 may be the only arc suppression device in the electric network or it may be a central arc suppression device, and the electric network may further comprise distributed compensation, i.e. one or more additional arc suppression devices distributed along the one or more electric line outlets (feeders) 20 and/or one or more additional arc suppression devices (not shown in the figures) located at the substation, for example. The arc suppression device 10 can be connected to the neutral point 21 of the electric network via an earthing transformer or any other suitable arrangement, for example. An admittance of the arc suppression device 10 is $\overline{Y}_{Coil}$ and the exemplary arc suppression device 10 as illustrated may comprise at least one adjustable coil. The arc suppression device 10 could comprise more than one adjustable and/or non-adjustable coil, for instance. $\bar{I}_{Coil}$ is the current flowing through the arc suppression device 10. The arc suppression device 10 may further include a controller for controlling, e.g. tuning, the adjustable coil, and also for generally controlling any functionality of the arc suppression device 10, for instance. Figures 1 and 2 further illustrate a current injection device (apparatus, equipment) 30, which is connected in parallel to the arc suppression device 10. The current injection device 30 may be a separate device or entity, possibly in a separate housing, or the current injection device 30 may be an integrated part of the arc suppression device 10, such as a module thereof, for example.

Current and voltage values used in the various embodiments described herein may be obtained by a suitable measuring arrangement, which may include current and/or voltage transducers (not shown in the figures) connected to the phases of the electric network or similar equipment, for example. Voltage and current quantities may also be measured at different locations, for instance. In existing electric networks and systems, such values are typically readily available and thus the implementation of the various embodiments does not necessarily require any separate or additional measuring arrangements. It should be noted that e.g. admittance, conductance, and/or susceptance could be used in any calculations and definitions disclosed herein in an analogous manner instead of impedance, resistance, and/or reactance, and vice versa, for example.

The figures also show a (first) control arrangement 11, such as a controller device or a control unit of the arc suppression device 10, located within the arc suppression device 10. Such a control arrangement 11 could also be located outside the arc suppression device 10 and could be configured to control more than one arc suppression devices 10, for example. In the exemplary systems of Figures 1 and 2, at least part of the functionality of the various embodiments may be located in the control arrangement 11, for example. The control arrangement 11 may be configured to receive necessary measurement data and/or perform at least some measurements by itself, and to control, i.e. tune, the adjustable coil of the arc suppression device 10. The figures further show a (second) control arrangement 31, such as a controller device or a control unit of the current injection device 30, located within the current injection device 30. Such a control arrangement 31 could also be located outside the current injection device 30. Such a control arrangement 31 could be a separate entity as illustrated in the examples or integrated with the control arrangement 11 of the arc suppression device 10, for example. In the exemplary systems of Figures 1 and 2, at least part of the functionality of the various embodiments may be provided by means of the control arrangement 31 of the current injection device 30, for example. It is thus possible that the functionalities of the first control arrangement 11 and the second control arrangement 31 are combined into one control arrangement which may thus control the operation of both the arc suppression devices 10 and the current injection device 30, for instance, and may implement at least part of the functionality of the various embodiments disclosed herein.

The following notation is used in Figure 1 (overbar denotes a complex quantity):

$\overline{E}_A$ is the phase A to neutral voltage of the source
$\overline{E}_B$ is the phase B to neutral voltage of the source
$\overline{E}_C$ is the phase C to neutral voltage of the source
$\overline{U}_A$ is the phase A to earth voltage at busbar
$\overline{U}_B$ is the phase B to earth voltage at busbar
$\overline{U}_C$ is the phase C to earth voltage at busbar
$\overline{U}_o$ is the neutral point voltage (the zero-sequence voltage) of the electric network, which can be measured e.g. at the busbar or at the source
$\bar{I}_{inj}$ is the injected current
$\overline{U}_{inj}$ is the output voltage of the current injection device
$\overline{U}_{oCoil}$ is the voltage over the arc suppression device
$\bar{I}_A$ is the phase A current at the source

$\bar{I}_B$ is the phase B current at the source

$\bar{I}_C$ is the phase C current at the source

$\bar{I}_{Coil}$ is the current through the arc suppression device

$\bar{Y}_A$ is the phase A to earth admittance of the electric network (excluding the arc suppression device 10)

$\bar{Y}_B$ is the phase B to earth admittance of the electric network (excluding the arc suppression device 10)

$\bar{Y}_C$ is the phase C to earth admittance of the electric network (excluding the arc suppression device 10)

$\bar{Y}_{oTr}$ is the zero-sequence admittance per phase of an earthing transformer or a main transformer, or another arrangement, which is used to form the neutral point of the electric network and through which the arc suppression device is connected to the electric network.

$\bar{Y}_{Coil} = G_{Coil} + j \cdot B_{Coil}$ is the admittance of the arc suppression device

j is the imaginary unit also known as a complex operator $G_{Coil}$ is the conductance of the arc suppression device corresponding to the parallel resistor and the natural losses of the coil

$B_{Coil}$ is the susceptance of the arc suppression device

The notation used in Figure 2 corresponds to that of Figure 1 except that in Figure 2 the inductive susceptance of the electric network due to possible distributed arc suppression device(s) $B_{CoilNet}$ is shown separately and the individual phase admittances of the electric line outlets 20 are presented with symmetrical phase admittances, whose sum equals the symmetrical network admittance:

$$\bar{Y}_{symm} = G_{symm} + j \cdot B_{symm} \qquad \text{(one third in each phase)}$$

Parameter $G_{symm}$ is the real part of the symmetrical network admittance. The sign is positive and it represents the shunt losses of the electric network (excluding the losses of the arc suppression device). Parameter $B_{symm}$ is the imaginary part of the symmetrical network admittance. The sign is positive (capacitive) and it represents the capacitive uncompensated earth-fault current of the electric network.

The natural asymmetry present in a real system is due to differences in individual phase admittances and it has thus in practice an arbitrary value. In Figure 2 it is presented with an asymmetry admittance concentrated into phase A and presented with the asymmetry admittance:

$$\bar{Y}_{asymm} = G_{asymm} + j \cdot B_{asymm} \qquad \text{(only in phase A in the example)}$$

The asymmetry admittance $\bar{Y}_{asymm} = G_{asymm} + j \cdot B_{asymm}$ represents the asymmetry of the phase-to-earth admittances of the electric network reduced to a lumped admittance in phase A. Parameter $G_{asymm}$ is the real part of asymmetry admittance. The sign may be positive or negative depending on the actual level of asymmetry. Parameter $B_{asymm}$ is the imaginary part of asymmetry admittance. The sign may be positive or negative depending on the actual level of asymmetry i.e. on the differences between the actual phase to earth admittances of the electric network.

The asymmetry admittance may also be calculated from phase-wise admittances as follows:

$$\bar{Y}_{asymm} = \bar{Y}_A + \bar{a}^2 \cdot \bar{Y}_B + \bar{a} \cdot \bar{Y}_C$$

The symmetry admittance can then be solved from the total admittance of the electric line outlets $\bar{Y}_{Net}$ as follows:

$$\bar{Y}_{symm} = \bar{Y}_{Net} - \bar{Y}_{asymm} = \bar{Y}_A + \bar{Y}_B + \bar{Y}_C - \bar{Y}_{asymm}$$

In the example of Figure 2 the following applies:

$$\bar{Y}_A = \frac{\bar{Y}_{symm}}{3} + \bar{Y}_{asymm} - j\frac{B_{CoilNet}}{3}$$

$$\bar{Y}_B = \frac{\bar{Y}_{symm}}{3} - j\frac{B_{CoilNet}}{3}$$

$$\overline{Y}_C = \frac{\overline{Y}_{symm}}{3} - j\frac{\overline{B}_{CoilNet}}{3}$$

According to an embodiment, a method for controlling an arc suppression device of a three-phase electric network is provided, wherein the arc suppression device has an adjustable admittance connected between a neutral point of the three-phase electric network and earth. According to an embodiment, the method comprises: a) performing a current injection into the neutral point of the three-phase electric network by using a frequency different from a frequency of the three-phase electric network, and b) obtaining a value of a zero-sequence impedance of the three-phase electric network, or of a quantity representative of the zero-sequence impedance of the three-phase electric network, during the current injection and/or obtaining a value of a zero-sequence admittance of the three-phase electric network, or of a quantity representative of the zero-sequence admittance of the three-phase electric network, during the current injection. According to an embodiment, the method further comprises: c) determining, based on the obtained value of the zero-sequence impedance, or of the quantity representative thereof, and/or based on the obtained value of the zero-sequence admittance, or of the quantity representative thereof, whether to initiate a tuning of the arc suppression device of the three-phase electric network. According to an embodiment, steps a) to c) may be repeated essentially continuously or at predetermined intervals.

According to an embodiment, the performing of the current injection comprises injecting a single frequency current signal into the neutral point of the three-phase electric network by using the frequency different from the frequency of the three-phase electric network. As an example, the injection current may be supplied to the three-phase electric network by any known injection method in parallel to network, e.g., into a power auxiliary winding of the arc suppression device 10 by the current injection device 30.

According to an embodiment, the value of the zero-sequence impedance of the three-phase electric network and/or the value of the zero-sequence admittance of the three-phase electric network may be obtained, e.g. calculated, on the basis of the zero-sequence voltage of the three-phase electric network during the current injection and the current used in the current injection. The values of the zero-sequence voltage of the three-phase electric network during the current injection and the current used in the current injection may be suitably measured. The calculation of the value of the zero-sequence impedance of the three-phase electric network and/or the value of the zero-sequence admittance of the three-phase electric network may be performed e.g. as follows:

$$\overline{Z}_0(\omega_i) = \frac{U_0(\omega_i)}{\overline{I}'_{inj}(\omega_i)} = \frac{1}{G_{Coil} - jB_{Coil} + G_{Net} + j(B_{cNet} - B_{CoilNet})}$$

$$= \frac{1}{G_{Coil} + \dfrac{1}{j\omega_i L_{Coil}} + G_{Net} + j\left(\omega_i C_{Net} - \dfrac{1}{\omega_i L_{Net}}\right)}$$

$$= \frac{1}{G_{0Tot} + j\left(\omega_i C_{Tot} - \dfrac{1}{\omega_i L_{Tot}}\right)} = \frac{1}{I_d - j\left(\dfrac{\omega_s}{\omega_i}I_{Ltot} - \dfrac{\omega_i}{\omega_s}I_{Ctot}\right)}U_{PE}$$

$$= \frac{1}{I_d - jI_v'}U_{PE} = \frac{I_d + j\left(\dfrac{\omega_s}{\omega_i}I_{Ltot} - \dfrac{\omega_i}{\omega_s}I_{Ctot}\right)}{I_d^2 + \left(\dfrac{\omega_s}{\omega_i}I_{Ltot} - \dfrac{\omega_i}{\omega_s}I_{Ctot}\right)^2}U_{PE} = \frac{I_d + jI_v'}{I_d^2 + I_v'^2}U_{PE}$$

$$= \frac{I_d}{I_d^2 + I_v'^2}U_{PE} + j\frac{I_v'}{I_d^2 + I_v'^2}U_{PE}$$

$$\overline{Y}_0(\omega_i) = \frac{\overline{I}'_{inj}(\omega_i)}{\overline{U}_0(\omega_i)} = G_{Coil} - jB_{Coil} + G_{Net} + j(B_{cNet} - B_{CoilNet})$$

$$= G_{Coil} + \frac{1}{j\omega_i L_{Coil}} + G_{Net} + j\left(\omega_i C_{Net} - \frac{1}{\omega_i L_{Net}}\right)$$

$$= G_{0Tot} + j\left(\omega_i C_{Tot} - \frac{1}{\omega_i L_{Tot}}\right) = \frac{1}{U_{PE}} \cdot \left(I_d - j\left(\frac{\omega_s}{\omega_i} I_{Ltot} - \frac{\omega_i}{\omega_s} I_{Ctot}\right)\right)$$

$$= \frac{I_d - jI_v'}{U_{PE}} = \frac{I_d}{U_{PE}} - j\frac{I_v'}{U_{PE}}$$

where:

$\overline{I}'_{inj}$ is the current injection reduced to the primary voltage level:

$$\overline{I}'_{inj} = \frac{U_{PAW}}{U_{PE}} \cdot \overline{I}_{inj}$$

where $U_{PAW}$ is the rated voltage of the power auxiliary winding of the arc suppression device
$\overline{U}_0$ is the zero-sequence voltage of the electric network
$\omega_i$ is the angular frequency of the current injection, which equals $2\pi \cdot f_i$; $f_i$ is the frequency of the current injection
$\omega_s$ is the synchronous angular frequency of the electric network, which equals $2\pi \cdot f_s$
$f_s$ is the synchronous frequency of the three-phase electric network (herein also referred as "network frequency"), e.g. 50Hz. Alternatively, $f_s$ can also be a measured network frequency, for example.
$G_{Coil}$ is the conductance of the arc suppression device corresponding to the parallel resistor and the natural losses of the device
$B_{Coil}$ is the susceptance of the arc suppression device
$G_{Net}$ is the zero-sequence conductance of the electric network excluding the arc suppression device 10
$B_{cNet}$ is the zero-sequence capacitive susceptance of the electric network excluding the arc suppression device 10
$B_{CoilNet}$ is the zero-sequence inductive susceptance of the electric network due to distributed arc suppression device(s)
$L_{Coil}$ is the inductance of the arc suppression device
$C_{Net}$ is the zero-sequence capacitance of the electric network excluding the arc suppression device 10
$L_{Net}$ is the zero-sequence inductance of the electric network due to distributed arc suppression device(s)
$L_{Tot}$ is the total zero-sequence inductance of the electric network (including the arc suppression device 10). In this case, $L_{Tot} = \frac{L_{Coil} \cdot L_{Net}}{L_{Coil} + L_{Net}}$
$C_{Tot}$ is the total zero-sequence capacitance of the electric network (including the arc suppression device 10). In this case, $C_{Tot} = C_{Net}$.
$G_{0Tot}$ is the total zero-sequence conductance of the electric network (including the arc suppression device 10). In this case, $G_{0Tot} = G_{Net} + G_{Coil}$ $I_v' = \frac{\omega_s}{\omega_i} I_{Ltot} - \frac{\omega_i}{\omega_s} I_{Ctot}$, is the magnitude of the frequency-scaled electric network detuning
$I_d$ is the total electric network damping
$I_{Ctot}$ is the total capacitive earth fault current at $f_s$ of the electric network
$I_{Ltot}$ is the total inductive earth fault current produced by the arc suppression device 10 and any distributed arc suppression device(s) at $f_s$ of the electric network
$U_{PE}$ is the rated phase to earth voltage of the electric network

The following conclusions can be made:

- From the above equation of $\overline{Y}_0(\omega_i)$ one can observe that a change in the detuning can be seen as a change in the imaginary part of the admittance $\overline{Y}_0$. Respectively, a change in the damping can be seen as a change in the real part of the admittance $\overline{Y}_0$.

- From the above equation of $\overline{Z}_0(\omega_i)$ it can be seen that a change in the detuning and/or damping results in a change in both the imaginary and the real part of the impedance $\overline{Z}_0$.

Generally e.g. a switching operation or a change in the detuning or damping in the electric network may be detected or identified when the absolute, real, imaginary and/or phasor value of the zero-sequence impedance and/or the zero-sequence admittance (or any other quantity proportional to said zero-sequence admittance and/or impedance, e.g., the impedance or admittance converted to a current form by multiplying it with the rated voltage) deviates from a reference value in any predetermined way, e.g. more than a selected tolerance and/or exceeds a predetermined threshold or exceeds the predetermined threshold for a predetermined period of time. According to an embodiment, such a reference value(s) may be predetermined and/or determined and stored (updated) for comparison e.g. after every successful tuning procedure of the arc suppression device by any known method in which point the electric network parameters are known.

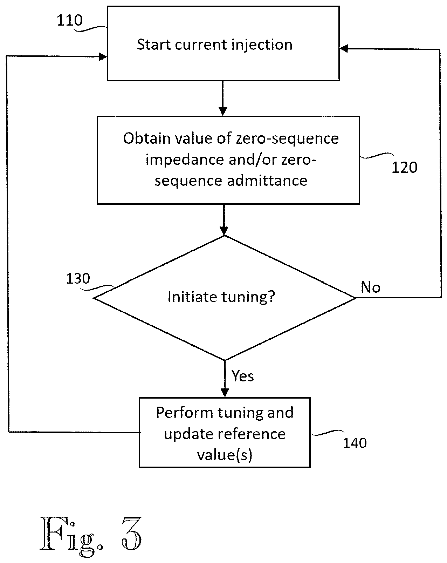

Figure 3 shows a flow diagram according to an embodiment. The current injection into the neutral point of the three-phase electric network by using the frequency different from the frequency of the three-phase electric network is started in step 110. The injection frequency is preferably equal to an injection frequency used for determining the one or more reference values. In step 120 a value of the zero-sequence impedance of the three-phase electric network, or of a quantity representative of the zero-sequence impedance of the three-phase electric network, during the current injection and/or a value of the zero-sequence admittance of the three-phase electric network, or of a quantity representative of the zero-sequence admittance of the three-phase electric network, during the current injection is/are obtained. In step 130, it is determined whether to initiate the tuning based on the obtained value(s) and one or more reference values. If it is determined not to initiate the tuning, the current injection 110 may be repeated e.g. essentially immediately or after a predetermined delay. If it is determined to initiate the tuning, the tuning is performed, and the reference value(s) may be updated in step 140. The reference value(s) may be updated to have the values(s) possibly obtained in connection with the tuning of the arc suppression device in step 140, i.e. corresponding to the calculated electric network parameters, after a successful tuning operation. Alternatively, the updated reference values(s) may be determined separately e.g. essentially directly after a successful coil tuning operation using current injection in a similar manner as in steps 110, 120, for example. After step 140, the current injection 110 may be repeated e.g. essentially immediately or after a predetermined delay, preferably using a frequency equal to the frequency for which the reference was established.

As an example, the change in the value of the zero-sequence admittance and the change in the value of the zero-sequence impedance can be calculated as follows:

$$\Delta\overline{Y}_0 = \overline{Y}_0 - \overline{Y}_{0\_ref}$$

$$= \frac{1}{U_{PE}} \cdot \left( I_{d\_ref} + \Delta I_d - j\left( \frac{\omega_s}{\omega_i}\left( I_{Ltot\_ref} + \Delta I_{Ltot} \right) - \frac{\omega_i}{\omega_s}\left( I_{Ctot\_ref} + \Delta I_{Ctot} \right) \right) \right)$$

$$- \frac{1}{U_{PE}} \cdot \left( I_{d\_ref} - j\left( \frac{\omega_s}{\omega_i} I_{Ltot\_ref} - \frac{\omega_i}{\omega_s} I_{Ctot\_ref} \right) \right)$$

$$= \frac{1}{U_{PE}} \cdot \left( \Delta I_d - j\left( \frac{\omega_s}{\omega_i} \Delta I_{Ltot} - \frac{\omega_i}{\omega_s} \Delta I_{Ctot} \right) \right)$$

$$\Delta\overline{Z}_0 = \overline{Z}_0 - \overline{Z}_{0\_ref}$$

$$= \frac{U_{PE}}{I_{d\_ref} + \Delta I_d - j\left( \frac{\omega_s}{\omega_i}\left( I_{Ltot\_ref} + \Delta I_{Ltot} \right) - \frac{\omega_i}{\omega_s}\left( I_{Ctot\_ref} + \Delta I_{Ctot} \right) \right)}$$

$$- \frac{U_{PE}}{I_{d\_ref} - j\left( \frac{\omega_s}{\omega_i} I_{Ltot\_ref} - \frac{\omega_i}{\omega_s} I_{Ctot\_ref} \right)}$$

where:

$\Delta$ denotes the change in the corresponding quantity, e.g., change in the detuning is denoted by $\Delta I_d$ so that $\Delta I_d = I_d -$

$I_{d\_ref}$. The notation without additional subscript illustrates a new determined value of the corresponding quantity, e.g. a new determined value of the damping is denoted by $I_d$.

_ref subscript denotes a reference value of the corresponding quantity, e.g., a reference value of the damping is $I_{d\_ref}$, a reference value of the zero-sequence admittance is $\overline{Y}_{0\_ref}$ and a reference value of the zero-sequence impedance is $\overline{Z}_{0\_ref}$.

To obtain the most accurate results, the applied frequency of the current injection is preferably essentially the same for both phasors: $\overline{Z}_0$ and $\overline{Z}_{0\_ref}$ or for $\overline{Y}_0$ and $\overline{Y}_{0\_ref}$.

The following conclusions can be made:

- From the above equation of $\Delta\overline{Y}_0$, the change in the value of the zero-sequence admittance, i.e. $\Delta\overline{Y}_0$, depends only on the change in the resistive ($\Delta I_d$), inductive ($\Delta I_{Ltot}$) and capacitive earth fault current ($\Delta I_{Ctot}$).
- From the above equation of $\Delta\overline{Z}_0$, the change in the value of the zero-sequence impedance, i.e. $\Delta\overline{Z}_0$, depends on the reference values ($I_{d\_ref}$, $I_{Ltot\_ref}$ & $I_{Ctot\_ref}$) as well as the changes in the resistive, inductive and capacitive earth fault currents ($\Delta I_d$, $\Delta I_{Ltot}$ & $\Delta I_{Ctot}$).

According to an embodiment, a relative change in the value of the zero-sequence impedance can then be calculated as a percentage as follows:

$$\Delta\overline{Z}_0\% = \frac{\left|\Delta\overline{Z}_0\right|}{\left|\overline{Z}_{0\_ref}\right|} \cdot 100\%$$

And in a similar manner, a relative change in the value of the zero-sequence admittance can be calculated as a percentage as follows:

$$\Delta\overline{Y}_0\% = \frac{\left|\Delta\overline{Y}_0\right|}{\left|\overline{Y}_{0\_ref}\right|} \cdot 100\%$$

According to an embodiment, the determining whether to initiate the tuning of the arc suppression device of the three-phase electric network may comprise comparing an obtained value of the zero-sequence impedance, or of the quantity representative thereof, with a first reference value and determining to initiate the tuning of the arc suppression device of the three-phase electric network in response to the obtained value of the zero-sequence impedance, or of the quantity representative thereof, deviating from the first reference value in a predetermined manner. Additionally or alternatively, the determining whether to initiate the tuning of the arc suppression device of the three-phase electric network may comprise comparing an obtained value of the zero-sequence admittance, or of the quantity representative thereof, with a second reference value and determining to initiate the tuning of the arc suppression device of the three-phase electric network in response to the obtained value of the zero-sequence admittance, or of the quantity representative thereof, deviating from the second reference value in a predetermined manner. According to an embodiment, the value of the zero-sequence impedance, or of the quantity representative thereof, is a complex value (phasor) and deviates from the first reference value in the predetermined manner if an absolute value of a difference between the value of the zero-sequence impedance, or of the quantity representative thereof, and the first reference value exceeds a predetermined first threshold. According to an embodiment, the value of the zero-sequence admittance, or of the quantity representative thereof, is a complex value (phasor) and deviates from the second reference value in the predetermined manner if an absolute value of a difference between the value of the zero-sequence admittance, or of the quantity representative thereof, and the second reference value exceeds a predetermined second threshold.

According to an embodiment, the tuning of the arc suppression device of the three-phase electric network may be performed in response to determining to initiate the tuning of the arc suppression device. The tuning of the arc suppression device of the three-phase electric network may be performed in any suitable manner known as such.

In the following some further examples (a non-exhaustive list) are given for possible conditions when the obtained value of the zero-sequence impedance or admittance, or of the quantity representative thereof, deviates (is determined to deviate) from the respective reference value in a predetermined manner.

1. Based on an absolute change/deviation in an absolute value of $\overline{Z}_0$ and/or $\overline{Y}_0$:

$$\Delta|\overline{Z}_0| = \left||\overline{Z}_0| - |\overline{Z}_{0\_ref}|\right| > \Delta|\overline{Z}_{0\_thres}|$$

$$\Delta|\overline{Y}_0| = \left||\overline{Y}_0| - |\overline{Y}_{0\_ref}|\right| > \Delta|\overline{Y}_{0\_thres}|$$

2. Based on a relative change/deviation in the absolute value of $\overline{Z}_0$ and/or $\overline{Y}_{00}$:

$$\Delta|\overline{Z}_0|\% = \frac{\left||\overline{Z}_0| - |\overline{Z}_{0\_ref}|\right|}{|\overline{Z}_{0\_ref}|} \cdot 100\% > \Delta|\overline{Z}_{0\_thres}|\%$$

$$\Delta|\overline{Y}_0|\% = \frac{\left||\overline{Y}_0| - |\overline{Y}_{0\_ref}|\right|}{|\overline{Y}_{0\_ref}|} \cdot 100\% > \Delta|\overline{Y}_{0\_thres}|\%$$

3. Based on an absolute change/deviation in a real value of $\overline{Z}_0$ and/or $\overline{Y}_0$:

$$\Delta real\{\overline{Z}_0\} = \left|real\{\overline{Z}_0\} - real\{\overline{Z}_{0\_ref}\}\right| > \Delta real\{\overline{Z}_{0\_thres}\}$$

$$\Delta real\{\overline{Y}_0\} = \left|real\{\overline{Y}_0\} - real\{\overline{Y}_{0\_ref}\}\right| > \Delta real\{\overline{Y}_{0\_thres}\}$$

4. Based on a relative change/deviation in the real value of $\overline{Z}_0$ and/or $\overline{Y}_0$:

$$\Delta real\{\overline{Z}_0\}\% = \frac{\left|real\{\overline{Z}_0\} - real\{\overline{Z}_{0\_ref}\}\right|}{\left|real\{\overline{Z}_{0\_ref}\}\right|} \cdot 100\% > \Delta real\{\overline{Z}_{0\_thres}\}\%$$

$$\Delta real\{\overline{Y}_0\}\% = \frac{\left|real\{\overline{Y}_0\} - real\{\overline{Y}_{0\_ref}\}\right|}{\left|real\{\overline{Y}_{0\_ref}\}\right|} \cdot 100\% > \Delta real\{\overline{Y}_{0\_thres}\}\%$$

5. Based on an absolute change/deviation in an imaginary value of $\overline{Z}_0$ and/or $\overline{Y}_0$:

$$\Delta imag\{\overline{Z}_0\} = \left|imag\{\overline{Z}_0\} - imag\{\overline{Z}_{0\_ref}\}\right| > \Delta imag\{\overline{Z}_{0\_thres}\}$$

$$\Delta imag\{\overline{Y}_0\} = \left|imag\{\overline{Y}_0\} - imag\{\overline{Y}_{0\_ref}\}\right| > \Delta imag\{\overline{Y}_{0\_thres}\}$$

6. Based on a relative change/deviation in the imaginary value of $\overline{Z}_0$ and/or $\overline{Y}_0$:

$$\Delta imag\{\overline{Z}_0\}\% = \frac{\left|imag\{\overline{Z}_0\} - imag\{\overline{Z}_{0\_ref}\}\right|}{\left|imag\{\overline{Z}_{0\_ref}\}\right|} \cdot 100\% > \Delta imag\{\overline{Z}_{0\_thres}\}\%$$

$$\Delta imag\{\overline{Y}_0\}\% = \frac{\left|imag\{\overline{Y}_0\} - imag\{\overline{Y}_{0\_ref}\}\right|}{\left|imag\{\overline{Y}_{0\_ref}\}\right|} \cdot 100\% > \Delta imag\{\overline{Y}_{0\_thres}\}\%$$

7. Based on an absolute change/deviation in a phasor value of $\overline{Z}_0$ and/or $\overline{Y}_0$:

$$\left|\Delta\overline{Z}_0\right| = \left|\overline{Z}_0 - \overline{Z}_{0\_ref}\right| > \left|\Delta\overline{Z}_{0\_thres}\right|$$

$$\left|\Delta\overline{Y}_0\right| = \left|\overline{Y}_0 - \overline{Y}_{0\_ref}\right| > \left|\Delta\overline{Y}_{0\_thres}\right|$$

8. Based on a relative change/deviation in the phasor value of $\overline{Z}_0$ and/or $\overline{Y}_0$:

$$\left|\Delta\overline{Z}_0\right|\% = \frac{\left|\overline{Z}_0 - \overline{Z}_{0\_ref}\right|}{\left|\overline{Z}_{0\_ref}\right|} \cdot 100\% > \left|\Delta\overline{Z}_{0\_thres}\right|\%$$

$$\left|\Delta\overline{Y}_0\right|\% = \frac{\left|\overline{Y}_0 - \overline{Y}_{0\_ref}\right|}{\left|\overline{Y}_{0\_ref}\right|} \cdot 100\% > \left|\Delta\overline{Y}_{0\_thres}\right|\%$$

where:

$\overline{Z}_0$ is the obtained (complex) value of the zero-sequence impedance of the three-phase electric network

$\overline{Z}_{0\_ref}$ is the (complex) reference value of the zero-sequence impedance of the three-phase electric network

$\Delta|\overline{Z}_0|$ is the absolute change in the absolute value between the two phasors: $\overline{Z}_0$, $\overline{Z}_{0\_ref}$

$\Delta|\overline{Z}_{0\_thres}|$ is a threshold setting for an allowed absolute change in the absolute value between the two phasors: $\overline{Z}_0$, $\overline{Z}_{0\_ref}$

$\Delta|\overline{Z}_0|\%$ is the relative change in the absolute value between the two phasors: $\overline{Z}_0$, $\overline{Z}_{0\_ref}$ in reference to $\overline{Z}_{0\_ref}$

$\Delta|\overline{Z}_{0\_thres}|$ is a threshold setting for an allowed relative change in the absolute value between the two phasors: $\overline{Z}_0$, $\overline{Z}_{0\_ref}$ in reference to $\overline{Z}_{0\_ref}$

$\Delta real\{\overline{Z}_0\}$ is the absolute change in the real value between the two phasors: $\overline{Z}_0$, $\overline{Z}_{0\_ref}$

$\Delta real\{\overline{Z}_{0\_thres}\}$ is a threshold setting for an allowed absolute change in the real value between the two phasors: $\overline{Z}_0$, $\overline{Z}_{0\_ref}$

$\Delta real\{\overline{Z}_0\}\%$ is the relative change in the real value between the two phasors: $\overline{Z}_0$, $\overline{Z}_{0\_ref}$

$\Delta real\{\overline{Z}_{0\_thres}\}\%$ is a threshold setting for an allowed relative change in the real value between the two phasors: $\overline{Z}_0$, $\overline{Z}_{0\_ref}$ in reference to $\overline{Z}_{0\_ref}$

$\Delta imag\{\overline{Z}_0\}$ is the absolute change in the imaginary value between the two phasors: $\overline{Z}_0$, $\overline{Z}_{0\_ref}$

$\Delta imag\{\overline{Z}_{0\_thres}\}$ is a threshold setting for an allowed absolute change in the imaginary value between the two phasors: $\overline{Z}_0$, $\overline{Z}_{0\_ref}$

$\Delta imag\{\overline{Z}_0\}\%$ is the relative change in the imaginary value between the two phasors: $\overline{Z}_0$, $\overline{Z}_{0\_ref}$ in reference to $\overline{Z}_{0\_ref}$

$\Delta imag\{\overline{Z}_{0\_thres}\}\%$ is a threshold setting for an allowed relative change in the imaginary value between the two phasors: $\overline{Z}_0$, $\overline{Z}_{0\_ref}$ in reference to $\overline{Z}_{0\_ref}$

$|\Delta\overline{Z}_0|$ is the absolute change in the phasor value between the two phasors: $\overline{Z}_0$, $\overline{Z}_{0\_ref}$

$|\Delta\overline{Z}_{0\_thres}|$ is a threshold setting for an allowed absolute change in the phasor value between the two phasors: $\overline{Z}_0$, $\overline{Z}_{0\_ref}$

$|\Delta\overline{Z}_0|\%$ is the relative change in the phasor value between the two phasors: $\overline{Z}_0$, $\overline{Z}_{0\_ref}$ in reference to $\overline{Z}_{0\_ref}$

$|\Delta\overline{Z}_{0\_thres}|\%$ is a threshold setting for an allowed relative change in the phasor value between the two phasors: $\overline{Z}_0$, $\overline{Z}_{0\_ref}$ in reference to $\overline{Z}_{0\_ref}$

$\overline{Y}_0$ is the obtained (complex) value of the zero-sequence admittance of the three-phase electric network

$\overline{Y}_{0\text{-}ref}$ is the (complex) reference value of the zero-sequence admittance of the three-phase electric network

$\Delta|\overline{Y}_0|$ is the absolute change in the absolute value between the two phasors: $\overline{Y}_0$, $\overline{Y}_{0\_ref}$

$\Delta|\overline{Y}_{0\_thres}|$ is a threshold setting for an allowed absolute change in the absolute value between the two phasors: $\overline{Y}_0$, $\overline{Y}_{0\_ref}$

$\Delta|\overline{Y}_0|\%$ is the relative change in the absolute value between the two phasors: $\overline{Y}_0$, $\overline{Y}_{0\_ref}$ in reference to $\overline{Y}_{0\_ref}$

$\Delta|\overline{Y}_{0\_thres}|$ is a threshold setting for an allowed relative change in the absolute value between the two phasors: $\overline{Y}_0$, $\overline{Y}_{0\_ref}$ in reference to $\overline{Y}_{0\_ref}$

$\Delta real\{\overline{Y}_0\}$ is the absolute change in the real value between the two phasors: $\overline{Y}_0$, $\overline{Y}_{0\_ref}$

$\Delta real\{\overline{Y}_{0\_thres}\}$ is a threshold setting for an allowed absolute change in the real value between the two phasors: $\overline{Y}_0$, $\overline{Y}_{0\_ref}$

$\Delta real\{\overline{Y}_0\}\%$ is the relative change in the real value between the two phasors: $\overline{Y}_0$, $\overline{Y}_{0\_ref}$ in reference to $\overline{Y}_{0\_ref}$

$\Delta real\{\overline{Y}_{0\_thres}\}\%$ is a threshold setting for an allowed relative change in the real value between the two phasors:

$\overline{Y}_0$, $\overline{Y}_{0\_ref}$ in reference to $\overline{Y}_{0\_ref}$

$\Delta imag\{\overline{Y}_0\}$ is the absolute change in the imaginary value between the two phasors: $\overline{Y}_0$, $\overline{Y}_{0\_ref}$

$\Delta imag\{\overline{Y}_{0\_thres}\}$ is a threshold setting for an allowed absolute change in the imaginary value between the two phasors: $\overline{Y}_0$, $\overline{Y}_{0\_ref}$

$\Delta imag\{\overline{Y}_0\}\%$ is the relative change in the imaginary value between the two phasors: $\overline{Y}_0$, $\overline{Y}_{0\_ref}$ in reference to $\overline{Y}_{0\_ref}$

$\Delta imag\{\overline{Y}_{0\_thres}\}\%$ is a threshold setting for an allowed relative change in the imaginary value between the two phasors: $\overline{Y}_0$, $\overline{Y}_{0\_ref}$ in reference to $\overline{Y}_{0\_ref}$

$|\Delta\overline{Y}_0|$ is the absolute change in the phasor value between the two phasors: $\overline{Y}_0$, $\overline{Y}_{0\_ref}$

$|\Delta\overline{Y}_{0\_thres}|$ is a threshold setting for an allowed absolute change in the phasor value between the two phasors: $\overline{Y}_0$, $\overline{Y}_{0\_ref}$

$|\Delta\overline{Y}_0|\%$ is the relative change in the phasor value between the two phasors: $\overline{Y}_0$, $\overline{Y}_{0\_ref}$ in reference to $\overline{Y}_{0\_ref}$

$|\Delta\overline{Y}_{0\_thres}|\%$ is a threshold setting for an allowed relative change in the phasor value between the two phasors: $\overline{Y}_0$, $\overline{Y}_{0\_ref}$ in reference to $\overline{Y}_{0\_ref}$.

According to an embodiment, the value of the zero-sequence impedance deviates from the respective (first) reference value in the predetermined manner if any one of the conditions 1-8 above for the zero-sequence impedance is true. According to an embodiment, the value of the zero-sequence admittance deviates from the respective (second) reference value in the predetermined manner if any one of the conditions 1-8 above for the zero-sequence admittance is true. In other words, any one of the conditions 1-8 above for the zero-sequence impedance or admittance could be selected and used for determining that the value of the zero-sequence impedance or admittance deviates from its respective reference value in the predetermined manner. Moreover, conditions corresponding to those of the above examples could be used for a quantity representative of the zero-sequence impedance or admittance, for example.

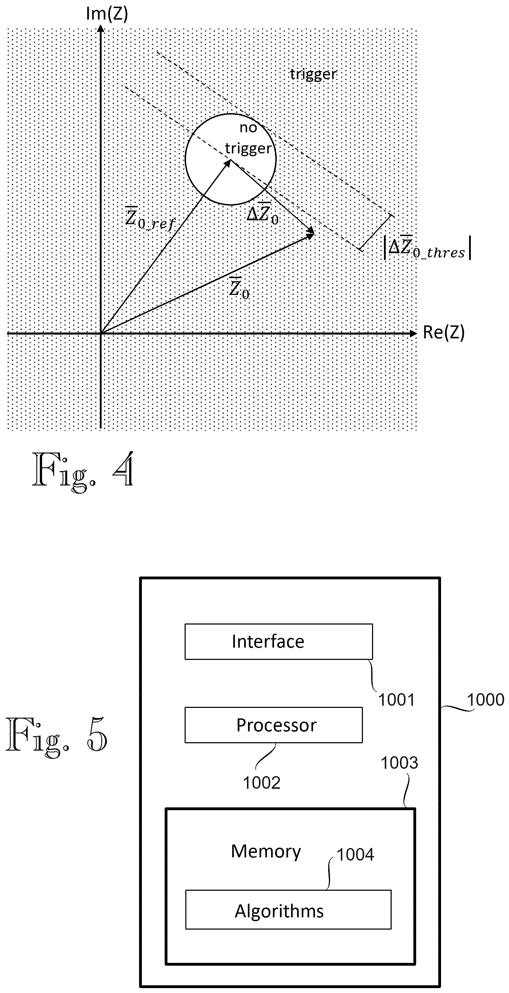

Figure 4 shows an exemplary diagram illustrating the implementation of the above exemplary conditions 7 and/or 8. The example of Figure 4 shows the zero-sequence impedance $\overline{Z}_0$ of the three-phase electric network, the reference value of the zero-sequence impedance is $\overline{Z}_{0\_ref}$ and the change in the value of the zero-sequence impedance $\Delta\overline{Z}_0$. The example of Figure 4 further shows a circle having a diameter of $|\Delta\overline{Z}_{0\_thres}|$ which represents a threshold such that if the length (absolute value) of phasor $\Delta\overline{Z}_0$ exceeds $|\Delta\overline{Z}_{0\_thres}|$, i.e. phasor $\Delta\overline{Z}_0$ extends outside of the circle, the tuning of the arc suppression device of the three-phase electric network may be initiated (triggered). Thus, the circle in the figure defines inside the circle a non-trigger area (non-operate area) of the tuning procedure and the dotted area outside of the circle represents a trigger area (operate area) of the tuning procedure. In the example, the zero-sequence impedance quantities could be replaced with corresponding zero-sequence admittance quantities or any other quantities representative of the zero-sequence impedance or admittance quantities, for example.

To calculate the zero-sequence impedance and/or the zero-sequence admittance at the frequency of the injection, the zero-sequence voltage and the injection current may be suitably measured and preprocessed, if necessary, which can include e.g., filtering and/or phasor calculation. The injection current may be measured directly at the injection source, e.g., from the power auxiliary winding of the arc suppression device where the current signal is injected. The zero-sequence voltage response can be measured from various points of the electric network, thus possibly resulting in alternative variants of the zero-sequence impedance and/or admittance. These alternative variants may include e.g. a voltage measurement winding of the arc suppression device, a power auxiliary winding of the arc suppression device 10, an open delta winding of a voltage transformer(s) and/or calculated vector sum of measured phase voltages, each with different advantages. The highest relative zero-sequence voltage change due to a switching operation or a change in the detuning can be measured from the open delta windings of the transformer or the calculated vector sum of the measured phase voltages. However, the measurement accuracy may be low at low voltage levels. The measurement accuracy may be increased when measured from the voltage measurement winding of the arc suppression device. The highest measurement accuracy may be obtained when measured from the power auxiliary winding of the arc suppression device, where the current signal is injected. The higher measurement accuracy may allow to use lower injection current amplitudes and/or to operate in networks with higher damping levels without extensive power requirements, for example. However, the detected relative voltage changes due to switching operation or change in the detuning may be lower.

According to an embodiment, the proposed solution according to the embodiments described above can be used either essentially continuously or discretely/periodically. As an example, the use of periodic injection could be preferable, or it could also be suitably intelligently coordinated to reduce the injection power requirement in certain networks and/or network configurations where e.g. the power requirement of the continuous injection might be extensive. I.e., the injection duty cycle could be suitably adapted according to the prevailing network zero-sequence system parameters, for example. This may allow using lower injection current amplitudes and/or to operate in networks with higher

damping levels without extensive power requirements, for example. Furthermore, with a short enough injection interval, e.g. in a range of about seconds to tens of seconds, this could allow essentially almost real time monitoring.

According to an embodiment, the injection frequency can be predetermined and/or adjustable to accommodate different levels of detuning, for example. Therefore, the frequency can be dynamically selected based on the prevailing electric network damping and/or detuning, for example. Without considering any power constraints essentially any arbitrary frequency unequal to the electric network frequency $f_s$ could be used. According to an embodiment, the injection frequency can deviate (+/-) from the electric network frequency $f_s$ e.g. from a fraction of one Hz to one or more Hz, e.g. about (+/-) 1Hz. This may depend on e.g. on an implementation of signal filters utilized and thus may be dependent on system characteristics. According to an embodiment, the injection frequency can be preselected and/or dynamically selected. Therefore, the frequency can be dynamically selected based on the prevailing electric network damping and/or detuning, for example However, according to an embodiment, the injection frequency is preferably the resonant frequency of the electric network or close to it. According to an embodiment, the amplitude may be adjustable to accommodate different levels of electric network damping and/or detuning, for example. Therefore, the amplitude can be dynamically selected based on the prevailing electric network damping and/or detuning, for example. The injection based zero-sequence impedance and/or admittance monitoring could be further combined and coordinated with e.g. any known solutions for monitoring the change in the natural zero-sequence voltage so that the injection-based monitoring might be only applied if the natural zero-sequence voltage falls below a selected threshold, for example.

The disclosed solution according to the embodiments described herein enables to detect or identify e.g. network switching operations and/or changes in the detuning in various three-phase electric networks, including essentially symmetrical networks, in essentially real time or almost in real time depending on the operation mode: continuous or discrete current injection. Also due to the utilization of the non-network frequency for the current injection, the solution is not disturbed by the electric network frequency disturbances or fluctuations in load currents and/or fluctuations network frequency, making the solution robust, for example. This may allow for a more sensitive detection of tuning changes, i.e., shorter triggering delays and/or lower permissible changes, for example. Moreover, as the impedance and/or admittance determination is used, any oscillations in the voltage and current are canceled when the impedance and/or admittance is calculated, which can improve stability and/or reduce the required signal stabilization time after injection is initiated, for example. The impedance and admittance are also not dependent on the injection current amplitude, for instance. It is further possible to detect tuning changes in the arc suppression device and/or connection state changes of a parallel resistor of the arc suppression device. In addition, since a single sinusoidal non-network frequency injection is sufficient, no multiple frequency components are needed for the current injection. Therefore the solution according to the embodiments described herein is simple to implement and the power requirement is not increased by additional frequency components, for instance. Moreover, by selecting the injection frequency optimally, e.g. by preselection and/or dynamically selecting the frequency, the power requirement of the injection device can be minimized.

The first control arrangement 11, the second control arrangement 31, or a combination thereof, and/or any other means for implementing at least part of the functionality according to any one of the embodiments herein may be implemented as one physical unit or as two or more separate physical units that are configured to implement the functionality. Herein the term 'unit' generally refers to a physical or logical entity, such as a physical device or a part thereof or a software routine. Figure 5 is a simplified block diagram illustrating some units for an apparatus (device, equipment) 1000 configured to perform at least some functionality of the first control arrangement 11, the second control arrangement 31, or a combination thereof, or generally any corresponding apparatus. In the illustrated example, the apparatus 1000 comprises one or more interface (IF) entities 1001, such as one or more user interfaces and/or data interfaces, and one or more processing entities 1002 connected to various interface entities 1001 and to one or more memories 1003. The one or more interface entities 1001 may be entities for receiving and transmitting information, such as communication interfaces comprising hardware and/or software for realising communication connectivity according to one or more communication protocols, or for realising data, e.g. measuring data, storing and fetching, and/or for providing user interaction via one or more user interfaces. A processing entity 1002 is capable to perform calculations and configured to implement at least part of functionalities/operations described above, with corresponding algorithms 1004 stored in the memory 1003. The processing entity 1002 may include one or more processors, controllers, control units, micro-controllers, etc. configurable to carry out e.g. embodiments, examples, implementations and/or operations described above. Generally, a processor may be a central processing unit, but the processor entity 1002 may be an additional operation processor or a multicore processor or a microprocessor, for instance. A memory 1003 may be usable for storing a computer program code required for one or more functionalities/operations described above, that is, the algorithms 1004 for implementing the functionality/operations described above. The memory 1003 may also be usable for storing, at least temporarily, other possible information required for one or more functionalities/operations described above. The memory 1003 may comprise a data buffer that may, at least temporarily, store for example measurement data and/or information received as a user input. The apparatus comprising the means for providing any embodiment described herein may be implemented at least partly by means by such apparatus 1000 as exemplified in Figure 5.

Generally, first control arrangement 11, the second control arrangement 31, or a combination thereof, and/or any other means for implementing at least part of the functionality according to any one of the embodiments herein may be implemented at least partly by means of one or more computers or corresponding digital signal processing (DSP) equipment provided with suitable software, for example. Such a computer or digital signal processing equipment preferably comprises at least a working memory (RAM) providing storage area for arithmetical operations, and a central processing unit (CPU), such as a general-purpose digital signal processor. The CPU may comprise a set of registers, an arithmetic logic unit, and a control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the various embodiments, or a part thereof, may further comprise suitable input means for receiving e.g. measurement and/or control data, and output means for outputting e.g. control or any other data. It is also possible to use a specific integrated circuit or circuits, such as application-specific integrated circuits (ASIC), digital signal processing devices (DSPD), programmable logic devices (PLD), field-programmable gate arrays (FPGA) and/or discrete electric components and devices for implementing the functionality according to any one of the embodiments.

The various embodiments described herein can be implemented at least partly in existing system elements, such as various arc suppression device(s) or similar device(s), and/or by using separate dedicated elements or devices in a centralized or distributed manner. Present arc suppression devices for electric networks may comprise processors and memory that may be utilized in the functions according to the various embodiments described herein. Generally, many electric devices, such as electric power systems, and components thereof, such as intelligent electronic devices, may comprise processors and memory that may also be utilized in implementing the functionality according to the various embodiments described herein. Thus, at least some modifications and configurations possibly required for implementing an embodiment could be performed as software routines, which may be implemented as added or updated software routines. If at least part of the functionality of any of the embodiments is implemented by software, such software may be provided as a computer program product comprising computer program code which, when run on a computer, causes the computer or corresponding arrangement to perform the functionality according to the embodiments as described herein. Such a computer program code may be stored or generally embodied on a computer readable medium, such as suitable memory, e.g. a flash memory or an optical memory, from which it is loadable to the unit or units executing the program code. In addition, such a computer program code implementing any of the embodiments may be loaded to the unit or units executing the computer program code via a suitable data network, for example, and it may replace or update a possibly existing program code. An embodiment may provide a computer program embodied on any client-readable distribution/data storage medium or memory unit(s) or article(s) of manufacture, comprising program instructions executable by one or more processors/computers, which instructions, when loaded into an apparatus, constitute the control arrangement, or any corresponding unit or an entity providing corresponding functionality, or at least part of the corresponding functionality. Programs, also called program products, including software routines, program snippets constituting "program libraries", applets and macros, can be stored in any medium and may be downloaded into an apparatus. In other words, each or some or one of the possible units/sub-units and/or algorithms for one or more functions/operations described above, for example by means of any of Figures 1 to 5 and any combination thereof, may be an element that comprises one or more arithmetic logic units, a number of special registers and control circuits.

It will be obvious to a person skilled in the art that, as the technology advances, the inventive concept can be implemented in various ways. The invention and its embodiments are not limited to the examples described above but may vary within the scope of the claims.

## Claims

1. A method for controlling an arc suppression device of a three-phase electric network, the arc suppression device having an adjustable admittance connected between a neutral point of the three-phase electric network and earth, the method comprising:

   a) performing a current injection into the neutral point of the three-phase electric network by using a frequency different from a frequency of the three-phase electric network;
   b) obtaining a value of a zero-sequence impedance of the three-phase electric network, or of a quantity representative of the zero-sequence impedance of the three-phase electric network, during the current injection and/or obtaining a value of a zero-sequence admittance of the three-phase electric network, or of a quantity representative of the zero-sequence admittance of the three-phase electric network, during the current injection; and
   c) determining, based on the obtained value of the zero-sequence impedance, or of the quantity representative thereof, and/or based on the obtained value of the zero-sequence admittance, or of the quantity representative thereof, whether to initiate a tuning of the arc suppression device of the three-phase electric network.

2. A method as claimed in claim 1, wherein the determining whether to initiate the tuning of the arc suppression device of the three-phase electric network comprises:

comparing the obtained value of the zero-sequence impedance, or of the quantity representative thereof, with a first reference value and determining to initiate the tuning of the arc suppression device of the three-phase electric network in response to the obtained value of the zero-sequence impedance, or of the quantity representative thereof, deviating from the first reference value in a predetermined manner; and/or
comparing the obtained value of the zero-sequence admittance, or of the quantity representative thereof, with a second reference value and determining to initiate the tuning of the arc suppression device of the three-phase electric network in response to the obtained value of the zero-sequence admittance, or of the quantity representative thereof, deviating from the second reference value in a predetermined manner.

3. A method as claimed in claim 2, wherein the value of the zero-sequence impedance, or of the quantity representative thereof, is a complex value and deviates from the first reference value in the predetermined manner if an absolute value of a difference between the value of the zero-sequence impedance, or of the quantity representative thereof, and the first reference value exceeds a predetermined first threshold.

4. A method as claimed in claim 2 or 3, wherein the value of the zero-sequence admittance, or of the quantity representative thereof, is a complex value and deviates from the second reference value in the predetermined manner if an absolute value of a difference between the value of the zero-sequence admittance, or of the quantity representative thereof, and the second reference value exceeds a predetermined second threshold.

5. A method as claimed in any one of claims 1 to 4, wherein the performing of the current injection comprises injecting a single frequency current signal into the neutral point of the three-phase electric network by using the frequency different from the frequency of the three-phase electric network.

6. A method as claimed in any one of claims 1 to 5, wherein the value of the zero-sequence impedance of the three-phase electric network and/or the value of the zero-sequence admittance of the three-phase electric network is/are obtained on the basis of a zero-sequence voltage of the three-phase electric network during the current injection and a current used in the current injection.

7. A method as claimed in any one of claims 1 to 6, wherein steps a) to c) are repeated essentially continuously or at predetermined intervals.

8. An apparatus for controlling an arc suppression device of a three-phase electric network, the arc suppression device having an adjustable admittance connected between a neutral point of the three-phase electric network and earth, the apparatus comprising:

means configured to perform a current injection into the neutral point of the three-phase electric network by using a frequency different from a frequency of the three-phase electric network;
means configured to obtain a value of a zero-sequence impedance of the three-phase electric network, or of a quantity representative of the zero-sequence impedance of the three-phase electric network, during the current injection and/or obtain a value of a zero-sequence admittance of the three-phase electric network, or of a quantity representative of the zero-sequence admittance of the three-phase electric network, during the current injection; and
means configured to determine, based on the obtained value of the zero-sequence impedance, or of the quantity representative thereof, and/or based on the obtained value of the zero-sequence admittance, or of the quantity representative thereof, whether to initiate a tuning of the arc suppression device of the three-phase electric network.

9. An apparatus as claimed in claim 8, wherein the means configured to determine whether to initiate the tuning of the arc suppression device of the three-phase electric network are configured to:

compare the obtained value of the zero-sequence impedance, or of the quantity representative thereof, with a first reference value and determine to initiate the tuning of the arc suppression device of the three-phase electric network in response to the obtained value of the zero-sequence impedance, or of the quantity representative thereof, deviating from the first reference value in a predetermined manner; and/or

compare the obtained value of the zero-sequence admittance, or of the quantity representative thereof, with a second reference value and determine to initiate the tuning of the arc suppression device of the three-phase electric network in response to the obtained value of the zero-sequence admittance, or of the quantity representative thereof, deviating from the second reference value in a predetermined manner.

10. An apparatus as claimed in claim 9, wherein the value of the zero-sequence impedance, or of the quantity representative thereof, is a complex value and deviates from the first reference value in the predetermined manner if an absolute value of a difference between the value of the zero-sequence impedance, or of the quantity representative thereof, and the first reference value exceeds a predetermined first threshold.

11. An apparatus as claimed in claim 9 or 10, wherein the value of the zero-sequence admittance, or of the quantity representative thereof, is a complex value and deviates from the second reference value in the predetermined manner if an absolute value of a difference between the value of the zero-sequence admittance, or of the quantity representative thereof, and the second reference value exceeds a predetermined second threshold.

12. An apparatus as claimed in any one of claims 8 to 11, wherein the means configured to perform the current injection into the neutral point of the three-phase electric network are configured to inject a single frequency current signal into the neutral point of the three-phase electric network by using the frequency different from the frequency of the three-phase electric network.

13. An apparatus as claimed in any one of claims 8 to 12, wherein the value of the zero-sequence impedance of the three-phase electric network and/or the value of the zero-sequence admittance of the three-phase electric network is/are obtained on the basis of a zero-sequence voltage of the three-phase electric network during the current injection and a current used in the current injection.

14. An apparatus as claimed in any one of claims 8 to 13, further comprising means configured to perform the tuning of the arc suppression device of the three-phase electric network in response to determining, by the means configured to determine whether to initiate the tuning of the arc suppression device, to initiate the tuning of the arc suppression device.

15. An arc suppression device for a three-phase electric network, the arc suppression device having an adjustable admittance and being configured to be connected between a neutral point of the three-phase electric network and earth, and comprising an apparatus as claimed in any one of claims 8 to 14.

EP 4 749 299 A1

BUSBAR

20

22

21

$\bar{E}_A$  $\bar{I}_A$  A

$\bar{E}_B$  $\bar{I}_B$  B

$\bar{E}_C$  $\bar{I}_C$  C

$3\bar{Y}_{oTr}$

$\bar{U}_o$

$\bar{U}_{oCoil}$

CONTROL

$B_{Coil}$  $G_{Coil}$  $\bar{U}_{inj}$  $\bar{I}_{inj}$

$\bar{Y}_{Coil}$

CONTROL

11

$\bar{I}_{Coil}$

10

31

30

$\bar{U}_A$  $\bar{Y}_A$

$\bar{U}_B$  $\bar{Y}_B$

$\bar{U}_C$  $\bar{Y}_C$

Fig. 1

Fig. 2

EP 4 749 299 A1

110 | Start current injection |

120 | Obtain value of zero-sequence impedance and/or zero-sequence admittance |

130 | Initiate tuning? | — No

Yes

140 | Perform tuning and update reference value(s) |

Fig. 3

Im(Z)

trigger

no
trigger

$\bar{Z}_{0\_ref}$

$\Delta\bar{Z}_0$

$\left|\Delta\bar{Z}_{0\_thres}\right|$

$\bar{Z}_0$

Re(Z)

Fig. 4

Fig. 5

Interface

1001

1000

Processor

1002

1003

Memory

1004

Algorithms

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2004/003578 A1 (ADAPTIVE REGELSYSTEME GMBH [AT]; LEIKERMOSER ALBERT [AT]) 8 January 2004 (2004-01-08) * page 7, lines 1-7; figure 1 * * page 10, lines 11-14 * * page 12, lines 23-32 * * claims 1,2,10 * ----- | 1-6,8-15 | INV. G01R31/08 H02H9/08 |
| X | CN 114 094 563 A (STATE GRID SHANDONG ELECTRIC POWER CO WEIFANG POWER SUPPLY CO ET AL.) 25 February 2022 (2022-02-25) * claim 1 * ----- | 1,5-7, 10,12, 13,15 | |
| X | WO 02/15355 A2 (ADAPTIVE REGELSYSTEME GES M B [AT]; LEIKERMOSER ALBERT [AT]) 21 February 2002 (2002-02-21) * abstract; figure 1 * * page 3, line 18 - page 5, line 6 * ----- | 1,5-7, 10,12, 13,15 | |
| | | | **TECHNICAL FIELDS SEARCHED (IPC)** G01R H02H |

The present search report has been drawn up for all claims

| Place of search | Date of completion of the search | Examiner |
|---|---|---|
| Munich | 29 April 2025 | Palukova, Mila |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 4683

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2025

| Patent document cited in search report | | Publication date | Patent family member(s) | | Publication date |
|---|---|---|---|---|---|
| WO 2004003578 | A1 | 08-01-2004 | AT | 413769 B | 15-05-2006 |
| | | | AU | 2003238492 A1 | 19-01-2004 |
| | | | EP | 1516193 A1 | 23-03-2005 |
| | | | WO | 2004003578 A1 | 08-01-2004 |
| CN 114094563 | A | 25-02-2022 | NONE | | |
| WO 0215355 | A2 | 21-02-2002 | AT | 411937 B | 26-07-2004 |
| | | | AU | 1212902 A | 25-02-2002 |
| | | | EP | 1307753 A2 | 07-05-2003 |
| | | | HU | 225927 B1 | 28-01-2008 |
| | | | WO | 0215355 A2 | 21-02-2002 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 1537371 A